Europäisches Patentamt

European Patent Office

Office européen des brevets

(19)

(11) Veröffentlichungsnummer: **0 041 228**
B1

(12) # EUROPÄISCHE PATENTSCHRIFT

(45) Veröffentlichungstag der Patentschrift:
19.09.84

(51) Int. Cl.³: **H 01 J 37/301, H 01 J 33/04**

(21) Anmeldenummer: 81104065.8

(22) Anmeldetag: 27.05.81

(54) Verfahren zur Herstellung eines Elektronenstrahlaustrittsfensters.

(30) Priorität: 02.06.80 DE 3020809

(43) Veröffentlichungstag der Anmeldung:
09.12.81 Patentblatt 81/49

(45) Bekanntmachung des Hinweises auf die Patenterteilung:
19.09.84 Patentblatt 84/38

(84) Benannte Vertragsstaaten:
CH DE FR GB IT LI SE

(56) Entgegenhaltungen:
DE - A - 2 501 885
FR - A - 2 066 038
US - A - 3 906 392

IEEE TRANSACTIONS ON ELECTRON DEVICES, Band ED-22, Nr. 7, Juli 1975 New York, US L.N. HEYNICK et al.: "Projection Electron Lithography Using Aperture Lenses", Seiten 399-409

(73) Patentinhaber: **M.A.N. MASCHINENFABRIK AUGSBURG-NÜRNBERG Aktiengesellschaft, Dachauer Strasse 667 Postfach 50 06 20, D-8000 München 50 (DE)**

(72) Erfinder: **Hirt, Alfred, Dr., Sörgelstrasse 13, D-8000 München 71 (DE)**

## Beschreibung

Die Erfindung bezieht sich auf ein Verfahren zur Herstellung eines Elektronenstrahl-Austrittsfensters mit einem Stützgitter.

Aus der DE-OS 2 501 885 ist ein Verfahren zur Herstellung eines elektronendurchlässigen Fensters bekannt, bei dem in einem mehrstufigen Beschichtungs- und Ätzverfahren unter Verwendung von Fotolack ein Stützgitter auf eine Fensterfolie abgeschieden wird. Mit diesem Verfahren lassen sich verhältnismäßig genaue Konturen im Stützgitter herstellen derart, daß ein Kontakt zwischen Elektronenstrahlen und Stützgitter durch geeignete Formgebung des Stützgitters vermieden werden kann. Dieses Verfahren ist jedoch aufgrund der zahlreichen Verfahrensstufen sehr aufwendig.

Die Problematik beim dort genannten Fenster liegt darin, daß dieses Fenster für maximale Elektronendurchlässigkeit möglichst dünn, für bestmögliche Festigkeit möglichst dick sein sollte. Außerdem steigt die durch inelastische Streuung hervorgerufene Abbremsung bzw. Absorption der Elektronen durch das Fenster mit der Ordnungszahl des Fensterwerkstoffs im periodischen System der Elemente, so daß eine Optimierung des Fensters zur Auswahl mechanisch nur schwer bearbeitbarer Substanzen, z. B. zu Kohlenstoff oder Silizium, als Fensterwerkstoff führt. Optimierung des Fensters bedeutet, daß dessen Dicke so klein wie möglich werden soll und die erzeugten Elektronenstrahlen optimal bzw. sehr gut ausgenutzt werden sollen, d. h. möglichst viele Elektronen durch das Fenster hindurchtreten sollen.

Was die mechanische Belastbarkeit des Fensters betrifft, so muß das Fenster den Druckunterschied 1 bar zwischen der den Elektronenstrahlerzeuger umgebenden Atmosphäre und dem im Elektronenstrahlerzeuger herrschenden Vakuum aufnehmen können. Die Zugfestigkeit des Fensterwerkstoffs bedingt jedoch eine obere Grenze für die bei gegebener Fensterdicke noch frei überspannbare Fläche. Nach Ardenne gilt näherungsweise

$$\frac{x}{D} \approx 5 \cdot 10^{-2}\, \frac{p}{Z}$$

worin » ≈ « »ungefähr gleich« bedeutet und x die Fensterdicke, D der Fensterdurchmesser (bei kreisrundem Fenster), p der genannte Druckunterschied in bar und Z die Zugfestigkeit des Fensterwerkstoffs in N/mm² ist; x/D ist dimensionslos.

Es ist zu beachten, daß die genannte Absorption zu einer Erwärmung des Fensterwerkstoffs führt, so daß die Zugfestigkeit bei der erhöhten Temperatur eingesetzt werden muß. Am Beispiel des Aluminiums ist dies besonders deutlich, da dort Z von 90 bei 20" C auf bei 500" C abnimmt.

Aus der obigen Formel erkennt man, daß die Größenordnung des Fensterdurchmessers etwa 10³mal die Fensterdicke sein muß. Das führt dazu, daß bei kleineren Durchmessern sehr dünne Folien verwendet werden müssen, die nur über Stützen gespannt werden können. Dies hat aber folgende Nachteile: Absorption an den Stützen und damit zu hohe Erwärmung und Röntgenstrahlung.

Aufgabe gemäß der Erfindung ist es, diese Nachteile zumindest weitgehend zu vermeiden und dabei den Herstellungsaufwand für das Fenster möglichst gering zu halten.

Diese Aufgabe wird erfindungsgemäß durch die Merkmale des Anspruchs gelöst.

Es ist zwar durch »IEEE TRANSACTIONS ON ELECTRON DEVICES, Juli 1975«, Seiten 400 bis 409, Copyright 1975 by The Institute of Electrical and Electronics Engineers, Inc., Printed in U.S.A., Annals No. 507ED005, bekannt, ein Elektronenbild über Aperturlinsen durch Elektronenprojektionslithographie zu erzeugen, jedoch handelt es sich dort nicht um die Herstellung eines Elektronenstrahl-Austrittsfensters, geschweige denn mit dessen eigenem Elektronenstrahlerzeuger mittels der Kathode desselben, die eine punktuell ausstrahlende Kathode ist. Auf der Basis der Erfindung kann mit dem Original-Elektronenstrahlerzeuger bzw. mit der Originalkathode, die diskrete bzw. punktuelle oder punktweise angeordnete Emissionsstellen aufweist bzw. mit der eigenen punktuellen Emission ohne großen Herstellungsaufwand, u. a. ohne Justierprobleme, das betreffende Emissionsmuster elektronenoptisch abgebildet und das Fenster so hergestellt werden, daß es im Betrieb zumindest weitgehend an genau definierten Stellen entsprechend diesem Muster bei sehr wenig Absorption durchlässig ist und durchstrahlt wird. Das Fenster kann ein Stützgitter bzw. Stützgitterstege praktisch genau an den Stellen bekommen, die nicht von Elektronen getroffen werden, also zwischen den durchlässigen Stellen bzw. Einzelfenstern. Das Stützgitter ist dadurch im Betrieb praktisch keiner Elektronenbelastung ausgesetzt. Es ist also ein optimiertes Fenster erzielbar. Es ist ferner möglich, ein optimiertes Fenster, das elektronenoptische Verzerrungen zuläßt bzw. ein unregelmäßiges Muster, z. B. elliptische (statt runde) Löcher, die infolge elektronenoptischer Verzerrungen entstehen, herzustellen. — Durch die Erfindung ist das Fenster auf das eigene Elektronenstrahlerzeugersystem optimierbar, und es wird zur Herstellung des Fensters keine andere Einrichtung benutzt, sondern der eigene Elektronenstrahlerzeuger.

Bei der Erfindung gestattet die Elektronenprojektionslithographie auch sehr kleine Durchmesser für die Einzelfenster bzw. für die dünne, freigespannte Folie. Beschränkungen hinsichtlich der Werkstoffauswahl für diese Fensterfolie bestehen nicht. Es ist auch möglich, für die Fensterfolie einen anderen Werkstoff als für das Stützgitter zu verwenden. Zum Beispiel kann eine dünne Graphitschicht — sie ist für Elektronenstrahlen gut durchlässig —, auf Keramik aufgetempert, verwendet werden, und wenn dann gemäß der Erfindung verfahren wird, so sind dünne Graphitfilm-Einzelfenster und ein Keramik-Stützgitter erzielbar. — Das Stützgitter kann aber auch z. B. aus Silizium bestehen, so wie die Einzelfenster z. B. aus Silizium bestehen können.

Die genannte, eigene Kathode kann z. B. auch eine Spitzenkathode (Draht mit dünnen V-förmigen Querteilen) oder eine Bürstenkathode (Draht mit dünnen Querborsten) sein. Insbesondere ist sie aber wie gesagt eine Dünnfilmfeldemissionskathode (DFFEK) mit vielen oder zahlreichen die Elektronen emittierenden Kegeln (Einzelkathoden), siehe »Journal of Applied Physics«, Vol. 47, No.12, Dez. 1976, Seiten 5248 bis 5263, Copyright 1976 American Institute of Physics, USA. Diese liefert wegen der vorherbestimmbaren Anordnung der Emissionspunkte bzw. Kegel und der Stabilität der Emission (z. B. kein thermisches Weglaufen der Emissionsspitzen) ideale Voraussetzungen für die Fensteroptimierung.

Die genannte, eigene Kathode weist die Emissionspunkte insbesondere in zueinander parallelen Reihen auf. Die genannte Spitzenkathode besteht dann aus zueinander parallelen Drähten, jeweils mit dünnen, V-förmigen Querteilen.

Der Elektronenstrahlerzeuger dient im allgemeinen zur Härtung (Elektronenstrahlhärtung), insbesondere einer Oberfläche oder Oberflächenschicht, ganz besonders einer zähflüssigen, vorzugsweise durch Bedrucken hergestellten Oberflächenschicht, z. B. einer Farbschicht. Die Oberflächenschicht befindet sich insbesondere auf einer Papierbahn.

Eine bei einem solchen Härten gewünschte Gleichmäßigkeit der Bestrahlung kann durch das Lochmuster simuliert werden, insbesondere indem, ausgehend von einer Kathode, bei der die Emissionspunkte zueinander paralleler Punktreihen zueinander versetzt angeordnet sind, die genannten Durchgangslöcher und Sacklöcher zueinander paralleler Lochreihen zueinander versetzt hergestellt werden. Die Strahlaufweitung durch Luftstreuung kann aber schon so groß sein, daß die Fensterstruktur nicht mehr in Erscheinung tritt, so daß diese Simulation entfallen kann.

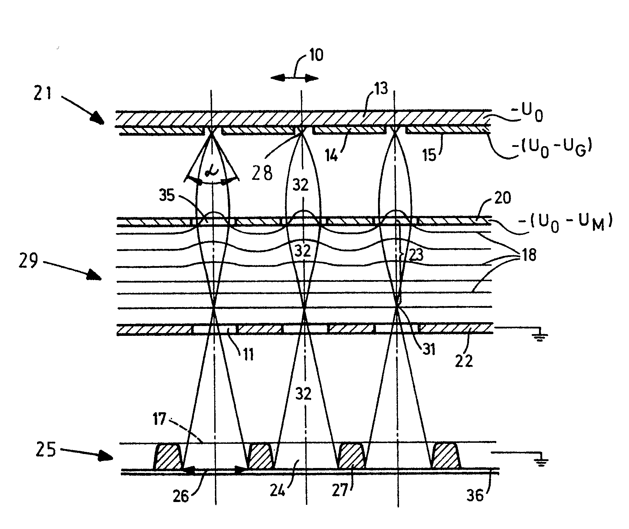

In der Zeichnung ist ein Ausführungsbeispiel des erfindungsgemäßen Verfahrens schematisch dargestellt.

Die Zeichnung zeigt einen Querschnitt durch eine plattenförmige Anordnung, bestehend aus einer Kathode 21, einer Aperturlinse 29 und einem Elektronenstrahl-Austrittsfenster 25, die als ebene, dünne Platten ausgebildet und planparallel zueinander angeordnet sind.

Die Kathode 21 ist eine unabgebrochen etwa 1500 mm lange und ferner 30 mm breite Dünnfilmfeldemissionskathode, die sich, was nicht dargestellt ist, im Vakuuminnenraum der eigenen, zylindrischen, horizontal angeordneten Elektronenstrahl-Erzeugungsröhre bzw. des Gehäuses derselben befindet und dort parallel zur Längsachse derselben bzw. desselben liegt. Diese Röhre mit ihrer Kathode 21 ist die, deren Fenster 25 hergestellt werden soll. Ihre Elektronenstrahlen dienen dem Elektronenstrahlhärten. In der Wand des genannten Gehäuses befindet sich in etwa 150 mm Entfernung unterhalb der Kathode 21 das etwa 1,5 mm dicke Fenster 25, zuerst als Rohling (ohne Elektronenstrahlen durchlässige Bereiche 24). Die Kathode 21 besteht im wesentlichen aus einem nicht dargestellten Träger aus Keramik und einer an diesem unten fest vorgesehenen Streifenreihe aus einer etwa 1 mm dicken Siliziumschicht, Silizium-Elektrode 13, einer etwa 2 μm dicken Siliziumoxidschicht 14 und einem etwa 0,5 μm dicken Molybdänfilm, Steuer-Elektrode 15, welche drei Schichten in dieser Reihenfolge nach unten aufeinanderfolgen, mit zahlreichen, gleichen Kegeln 28 (Einzelkathoden) aus Molybdän. Jeder Kegel 28 befindet sich in einer runden Höhlung 19 in der Schicht 14 mit seiner Grundfläche an der Schicht 13 und mit seinem spitzen Ende in einer runden Öffnung im Film 15. Die Kegel 28 sind in Richtung des Doppelpfeils 10 aufeinanderfolgend und parallel dazu, also in mehreren zueinander parallelen Reihen, angeordnet.

Mit $U_0$ (0 = Null) ist die Spannung an der Silizium-Elektrode 13 bezeichnet, mit $-(U_0-U_G)$ (G = Gitter) die Spannungsdifferenz zwischen Silizium-Elektrode 13 und der Steuer-Elektrode 15 und mit $-(U_0-U_M)$ (M = Maske, $U_M$ = Nachbeschleunigungsspannung) die Spannungsdifferenz zwischen der Silizium-Elektrode 13 und einer Lochmaske 20 der Aperturlinse 29.

Die Kathode 21 emittiert die Elektronen an definierten Punkten, und zwar an den Kegeln 28, d. h. an den Spitzen derselben, wobei der Emissionsfleck jedes Punkts einen Durchmesser von etwa 50 nm ( = 50 Nanometer = $10^{-9}$m = 0,001 μ) hat. Ohne Nachbeschleunigung würde der Emissionswinkel $\alpha$ des gestrichelt dargestellten Emissionskegels 12 etwa 60° betragen. Der Emissionskegel bzw. -winkel ist aber durch Nachbeschleunigung verkleinert — siehe die »zuckerhut«-förmigen Elektronenstrahlen 32.

Der Fensterrohling weist an der unteren Seite eine etwa 2 μ dicke, elektronendurchlässige Schicht 36 aus Fensterwerkstoff auf. In der Röhre bzw. im Gehäuse derselben befindet sich im Raum zwischen der Kathode 21 und dem Fensterrohling die aus Lochmasken 20 und 22 bestehende Aperturlinse 29. Die Lochmaske 20 befindet sich etwa 50 mm unterhalb der Kathode 21 und die Lochmaske 22 etwa 50 mm unterhalb der Lochmaske 20, und zwar so, daß die Kegel 28, die Durchgangslöcher 35 der Lochmaske 20 und die Durchgangslöcher 11 der Lochmaske 22 vertikal fluchten. Die Lochmasken 20 und 22 können ebenfalls mit der Kathode 21 in der eigenen Röhre hergestellt werden. Die Durchmesser des Durchgangslochs 11 und des Durchgangslochs 35 sind etwa gleich groß.

Die Lochmaske 20 ist eine auf dem Zwischenpotential $-(U_0-U_M)$ liegende Elektrode. Die Lochmaske 22 ist als Anode ausgebildet. Die Lochmaske 22 und der Fensterrohling 25 sind geerdet. Die von den Kegeln 28 ausgehenden, Elektronenstrahlen 32 (Elektronenvorhang) durchstoßen die Durchgangslöcher 35 und 11 der Aperturblende, wobei jedes Durchgangsloch 35 als Einzellinse wirkt und den Elektronenstrahl 32 fokussiert. Die Elektronenstrahlen 32 treffen auf eine nicht dargestellte, elektronenempfindliche Schicht 17 des Fensterrohlings, in die sie ein Abbild der eigenen Kathode 21 mit stark vergrößerten Einzelfensterflecken einbrennen. Die Lochmaske 22 hat die Aufgabe, zwischen sich und dem Fensterrohling einen feldfreien Raum zu schaffen, und zwar damit die Schicht 17 nicht als Elektrode wirkt, d. h. elektrisch sein muß, denn das Material der Schicht 17 ist im allgemeinen nicht elektrisch leitfähig.

Die Brennweite der Einzellinse (Durchgangsloch 35) ist mit 23 und der zugehörige Brennpunkt mit 31 bezeichnet. Äquipotentiallinien zwischen den Lochmasken 20 und 22 sind mit 18 bezeichnet. Durch Änderung der Spannungsdifferenz $-(U_0-U_M)$ kann man die Brennweite (Fokussierungslänge) 23 verändern und somit das genannte Abbild variieren, d. h. die Größe der Einzelfensterflecken ändern.

Zuletzt werden bei den Einzelfensterflecken Sacklöcher, d. h. elektronendurchlässige Bereiche 24 bis zur Schicht 36 in den Fensterrohling eingeätzt, so daß dünne Filme als Einzelfenster 26 und ferner ein aus Stegen um die Sacklöcher 24 herum bestehendes Stützgitter 27 übrigbleiben.

An die Stelle der zueinander parallelen Lochreihen aus den Durchgangslöchern 11 können durchgehende Längsschlitze mit einer Mindestbreite gleich dem dortigen Durchmesser des Strahls 32 treten.

Der Ätzvorgang kann außerhalb des Gehäuses des Elektronenstrahlerzeugers bzw. der Elektronenstrahl-Erzeugungsröhre oder, unter eventuellen Schützen von Oberflächen im Gehäuseinneren durch entfernbaren Überzug, innerhalb dieses Gehäuses erfolgen, im letztgenannten Fall, insbesondere durch Füllen des Gehäuses mit einem flüssigen Ätzmittel. Das flüssige Ätzmittel ist aber, ob für außerhalb oder innerhalb des Gehäuses, praktisch immer von der Art, daß es nur bei den genannten Flecken, aber nicht neben diesen wirkt bzw. ätzt.

**Patentanspruch**

Verfahren zur Herstellung eines Elektronenstrahl-Austrittsfensters (25) mit einem Stützgitter (27) und elektronendurchlässigen Bereichen (24, 26) für einen Elektronenstrahl-Erzeuger, der eine die Elektronen an vielen voneinander getrennten Punkten emittierende Kathode (21), insbesondere Dünnfilm-Emissionskathode, und den einzelnen elektronenemittierenden Punkten (28) zugeordnete Aperturlinse (29) aufweist, wobei jedem elektronenemittierenden Punkt der Kathode ein elektronendurchlässiger Bereich des Fensters zugeordnet und mit dem von diesem ausgehenden Strahl (32) ausgerichtet ist, bei welchem Verfahren zuerst eine auf einem Rohling aufgebrachte elektronenempfindliche Schicht (17) den im Elektronenstrahl-Erzeuger selbst hergestellten Elektronenstrahlen (32) ausgesetzt wird und der Rohling anschließend an den den Strahlen ausgesetzten Stellen geätzt wird, so daß an den den Strahlen ausgesetzten Stellen elektronendurchlässige Bereiche (24) und an den übrigen Stellen das Stützgitter (27) entstehen.

**Claim**

A method of preparing an electron beam exit window (25) having a support lattice (27) and electronpervious zones (24, 26) for an electron beam generator having a cathode (21), more particularly a thin film emission cathode, emitting the electrons at a number of separate places, and aperture lenses (29) associated with the various electron-emitting places (28), an electron-pervious zone of the window being associated with each such place of the cathode and being aligned with the beam (32) issuing therefrom, wherein an electron-sensitive layer (17) which has been applied to a blank is exposed to the electron beams (32) procuced in the electron beam generator itself, whereafter the blanc is etched at the places exposed to the beams, so that electron-pervious zones (24) arise at the places experiencing the beams and the support lattice (27) arises at the other places.

**Revendication**

Procédé de fabrication d'une fenêtre de sortie (25) pour faisceaux d'électrons avec une grille-support (27) et des zones (24, 26) perméables aux électrons pour un générateur de faisceaux d'électrons, présentant une cathode (21) à nombreux points d'émission d'électrons, particulièrement une cathode d'émission par effet de champ à film mince, et des lentilles d'ouverture (29) associées aux différents points (28) d'émission d'électrons, une zone perméable aux électrons de la fenêtre étant associée à chaque point d'émission d'électrons de la cathode et étant alignée avec le faisceau (32) partant de celui-ci, procédé dans lequel une couche (17) sensible aux électrons disposée sur une ébauche est d'abord exposée aux faisceaux d'électrons (32) produits dans le générateur de faisceaux d'électrons lui même et l'ébauche est ensuite attaquée chimiquement dans les zones exposées aux faisceaux, de sorte que l'on crée des zones (24) perméables aux électrons dans les zones exposées aux faisceaux et la grille-support (27) dans les autres zones.